# EUROPÄISCHE PATENTSCHRIFT

(11) **EP 1 541 234 B1**
(45) Veröffentlichungstag und Bekanntmachung des Hinweises auf die Patenterteilung: **28.02.2007**
(21) Anmeldenummer: 03028065.5
(22) Anmeldetag: 08.12.2003
(51) Int. Cl.: B01L 3/00, B81C 1/00

(54) **Hybrider Mikrofluidik-Chip und Verfahren zu seiner Herstellung**
Hybrid microfluidic chip and method of manufacture
Plaquette hybride microfluidique et procedé de fabrication

(43) Veröffentlichungstag der Anmeldung: 15.06.2005
(73) Patentinhaber: Fraunhofer-Gesellschaft zur Förderung der angewandten Forschung e.V., 80686 München (DE)
(72) Erfinder: Wagler, Patrick, 56154 Boppard (DE); Tangen, Uwe, 53639 Königswinter (DE); Chemnitz, Steffen, 57072 Siegen (DE); MCCaskill, John Simpson, 53229 Bonn (DE); Maeke, Thomas, 53229 Bonn (DE); Jünger, Martina, 53619 Rheinbreitbach (DE)
(74) Vertreter: Hilleringmann, Jochen

(56) Entgegenhaltungen:
- US-B1- 6 548 895

## Beschreibung

Die Erfindung betrifft ein Mikrofluidik-System, bei dem als Trägersubstrat für z.B. der Manipulation, Selektion, den Transport und/oder Detektion von chemischen Verbindungen, Biomolekülen, Biomolekülkomplexen, biologischen Zellen oder Zellbestandteilen/-bruchstücken dienenden Elektroden sowie deren elektrische Anbindung herkömmliche Leiterplatinen-Materialien wie z.B. FR4 (Epoxyd-Glasfasergewebe), FR5, Teflon und Polyimid verwendet werden. Ferner betrifft die Erfindung ein Verfahren zur Herstellung hybrider Mikrofluidik-Chips unter Verwendung konventioneller Leiterplatinen und Mehrlagentechnik zur elektrisch aktiven Manipulation und Detektion von chemischen Verbindungen, Biomolekülen, Mikropartikeln oder biologischen Zellen.

Es ist bekannt, als Substrat für Mikrofluid-Materiallagen, in denen Mikrokanäle bildende Vertiefungen unterschiedlicher Tiefe ausgebildet sind, Silizium, Glass und Kunststoff zu verwenden. Diese Materialien lassen sich mittels (soft-) lithographischer Prozesse und/oder geeigneten Abformverfahren auf den Oberflächen gut beherrschbar und reproduzierbar strukturieren.

Die Ausbildung von elektrischen Verbindungsebenen ist auf bzw. in Silizium, Glass oder Kunststoff nur mit erhöhtem technologischen Aufwand möglich; dies gilt insbesondere dann, wenn mehrere elektrisch leitende Ebenen übereinander anzuordnen sind, was insbesondere bei komplexen Anforderungen erforderlich sein kann um ein effektives Routing der elektrischen Leiterbahnen zu ermöglichen.

Kostengünstige Substrate mit mehreren elektrisch leitenden (Leiterbahn-) Ebenen sind dagegen aus der konventionellen Platinentechnik bekannt. Die irreversible mechanische Anbindung derartiger Multi-Layer-Platinen an eine Mikrokanal-Materiallage bereitet jedoch Schwierigkeiten.

Eine Aufgabe der Erfindung ist es daher, ein Verfahren zur Kopplung von leicht handhabbaren mehrlagigen Platinensubstraten mit einer biokompatiblen Fluidiksubstratkomponente sowie einen derartig erstellten Mikrofluidik-Chip anzugeben.

Zur Lösung dieser Aufgabe wird mit der Erfindung ein Verfahren zur Herstellung eines hybriden Mikrofluidik-Systems vorgeschlagen, das versehen ist mit:
- einer Leiterplatine, die eine Polymer-Trägerschicht (Platinenmaterial) aufweist, wobei mindestens eine Seite der Trägerschicht mit einer elektrisch leitenden Schicht versehen ist, die mehrere Elektroden aufweist, und auf die elektrisch leitende Schicht unter Freilassung zumindest einer der Elektroden eine oder mehrere photolithographisch bzw. mittels Elektronenstrahl strukturierbare Lack- bzw. Polymerschicht (-en) auf Acryl-, Epoxidharz-, Phenolharz-, Silikonharz-Fluorpolymerbasis aufgebracht ist, und
- einer oder mehrerer Mikrokanal-Materiallage(n) mit einer Außenseite, in die Mikrokanäle bildende Vertiefungen eingebracht sind,
- wobei die Materiallage PDMS (Polydimetylsiloxan, SYLGARD^{®}, DOW Corning), andere Organosiloxane sowie deren Polymerisationsprodukte, Silikone, Polyacrylate (wie z.B. PMMA), und/oder Elastomere mit sauerstoff- und/oder stickstoffhaltigen funktionalen Gruppen (z.B. Polysulfon, -imid, -carbonat und/oder -acrylnitril aufweist,
- wobei die Vertiefungen aufweisende Außenseite der Mikrokanal-Materiallage die Photolackschicht der Leiterplatine derart kontaktiert, dass die mindestens eine Elektrode mit einer der Vertiefungen fluchtet und
- wobei die Außenseite der Materiallage fluiddicht mit der Lack- bzw. Polymerschicht der Leiterplatine verbunden ist.

In vorteilhafter Weiterbildung der Erfindung ist vorgesehen, dass die Photolackschicht das Epoxidharz SU-8^{®} (MicroChem Corp.), Bisbenzocyclobuten (Cycloten^{®} , DOW) oder CYTOP^{®} (Cyclic Transparent Optical Polymer, Asahi Glass Company) aufweist.

Schließlich kann vorteilhafterweise die fluiddichte Verbindung zwischen der Außenseite der Mikrokanal-Materiallage und der Lack- bzw. Polymerschicht der Leiterplatine Plasma und vorzugsweise Sauerstoffplasma unterstützt sein.

In weiterer vorteilhafter Ausgestaltung der Erfindung ist vorgesehen, dass die Leiterplatine auf der mindestens eine ihrer beiden Seiten eine mehrlagige elektrisch leitende Schicht mit mehreren gegeneinander elektrisch isolierten elektrisch leitenden Schichten aufweist, von denen die oberste die Elektroden aufweist.

Ferner ist es von Vorteil, wenn bei dem erfindungsgemäßen System die Leiterplatine beidseitig mit jeweils einer ein- oder mehrlagigen elektrisch leitenden Schicht versehen ist und Durchkontaktierungsöffnungen zur elektrischen Verbindung der elektrisch leitenden Schichten aufweist.

Schließlich kann mit Vorteil vorgesehen sein, dass die Leiterplatine zur Fluidanbindung der Mikrokanäle mindestens einen Fluidkanal aufweist, der sich von der mit der Mikrokanal-Materiallage verbundenen einen Seite der Leiterplatine zu deren gegenüberliegenden anderen Seite erstreckt.

Als besonders vorteilhafte Materialkombination hat sich SU-8^{®} als Photolackschicht und PDMS als Mikrokanal-Materiallage herausgestellt.

Die Erfindung betrifft insbesondere rekonfigurierbare (d.h. schaltbare) Elektrodenanordnungen auf mehrlagigen PCBs (Printed Circuit Boards), die durch eine oder mehrere dünne, lithografisch strukturierbare Polymerschichten (z.B. Photoresist SU-8^{®}) versehen sind und als Substrat für Mikrofluidik-Systeme eingesetzt werden. Die Polymerschichten fungieren als biokompatible, planarisierende und andersweitige physikalische Schutz- und/oder Trennschichten, sowie als haftvermittelndes Substrat zur PDMS-Fluidikebene und können zusätzlich als strukturierbares Material zur Erzeugung von Mikrokanälen in der Mikrofluidik und Lötstoppmaske für die Bestückung des Platinenmaterials mit elektronischen Bauelementen dienen. Mit anderen Worten wird also die Fluidikebene nicht notwendigerweise durch die Mikrokanallage allein sondern zusätzlich auch durch entsprechende Strukturen in der Fotolackschicht bestimmt.

Mit der Konzeption hybrider Biochips auf PCB-Basis ist es erstmalig gelungen, mikrofluidische Komponenten mit mehreren elektrischen Layern zu kombinieren. Derartige Biochips erlauben die online gesteuerte Manipulation von elektrisch geladenen Molekülen und Mikropartikeln bei gleichzeitiger optischer Überwachung. Letzteres bildet die Grundlage zur on-chip Integration biochemischer Standardverfahren wie z.B. der Hybridisierung und Amplifikation von Nukleinsäuren. Der Biochip auf der Basis konventioneller Leiterplattentechnik eröffnet somit neue Anwendungsfelder in den Bereichen der biomolekularen Diagnostik und kombinatorischen Chemie bis hin zur Mikroreaktionstechnik und evolutiven Biotechnologie.

Integrierte Anwendungen auf Biochips in der Biotechnologie sind derzeit limitiert durch zeitaufwändige Entwicklungszyklen zur Herstellung anwendungsspezifischer Systeme. Vom Nutzer programmierbare Biochips ermöglichen mittels digital gepulsten Mikroelektroden einen effizienten Transport von Biomolekülen (DNA, Proteine etc.) über Mikrofluidikkanäle sowohl zu on-chip integrierten Mikroreaktoren als auch Detektionsorten, wobei sich die Biomoleküle mittels laserinduzierter Fluoreszenzdetektion verfolgen lassen.

Diese hybriden Biochips wurden bisher mittels kostenintensiver halbleitertechnologischer Herstellungsverfahren gefertigt, da sich die für mikrofluidische Anwendungen typischen Strukturgrößen mit etablierten Verfahren der Mikrosystemtechnik erfolgreich realisieren ließen.

Eine Vielzahl von - hauptsächlich auf Basis von Silizium, Glas oder Polydimethylsiloxan (PDMS) gefertigten - Mikrosystemen mit meist einer mikrofluidischen und/oder elektrischen Ebene zeugen von dieser Entwicklung. Für den elektrokinetischen Molekültransport innerhalb dieser fluidischen Systeme wird jedoch zunehmend eine hohe Anzahl von on-chip Mikroelektrodenanordnungen benötigt, da die Aktorelektroden auf der Chipkomponente einzeln angesteuert werden müssen. Letzteres macht das Routing der erforderlichen Leiterbahnen auf nur einem elektrischen Layer sehr aufwändig und schränkt die Skalierbarkeit der Integration enorm ein.

Um dieses Problem zu vermeiden, wird das halbleitertechnologisch prozessierte Siliziumsubstrat erfindungsgemäß durch ein PCB ersetzt. Damit lassen sich kostengünstig mehrere elektrische Lagen realisieren, die es ermöglichen, die Mikroelektroden effektiv zu kontaktieren. Diese neuartigen Low-Cost-Biochips enthalten eine mikrofluidische Komponente aus vorzugsweise (transparentem) PDMS und eine Leiterplatine mit vorzugsweise mehreren elektrischen Ebenen zur einfachen und skalierbaren Kontaktierung der Mikroelektroden auf der Oberseite der elektrischen Layer.

Folgende Ausführungsvarianten der erfindungsgemäßen hybriden PCB-Chips sind beispielsweise möglich:
1. Mehrlagiges PCB-Substrat mit einer oder mehreren Durchgangsbohrung (-en) zur Kontaktierung der Mikrokanal-Materiallage in PDMS bzw. o.g. Materialien auf der Oberseite des Chips.
2. Mehrlagiges PCB-Substrat mit einer oder mehreren Durchgangsbohrungen zur Kontaktierung der Mikrokanal-Materiallagen in PDMS bzw. o.g. Materialien auf der Ober- und Unterseite des Chips.
3. Mehrlagiges PCB-Substrat mit einer oder mehreren Durchgangsbohrungen und mit einer oder mehreren Mikrokanal-Materiallagen in PDMS bzw. o.g. Materialien und mit einer Mikrokanäle aufweisenden Polymehrschicht (z.B. SU-8) auf der Oberseite des Chips.
4. Mehrlagiges PCB-Substrat mit Durchgangsbohrungen und zwei Mikrokanal-Materiallagen in z.B. PDMS und einer Mikrokanalstruktur in z.B. SU-8 auf der Oberseite des Chips.
5. Mehrlagiges PCB-Substrat mit Durchgangsbohrungen und zwei Mikrokanal-Materiallagen in z.B. PDMS und zwei Mikrokanalstrukturen in z.B. SU-8 auf der Ober- und Unterseite des Chips.

Die Erfindung wird nachfolgend anhand der Zeichnung näher beschrieben, in der
- Fig. 1: die Abfolge der einzelnen Herstellungsschritte nach der Erfindung zeigt und
- Fig. 2: einen Schnitt durch einen erfindungsgemäßen Biochip zeigt.

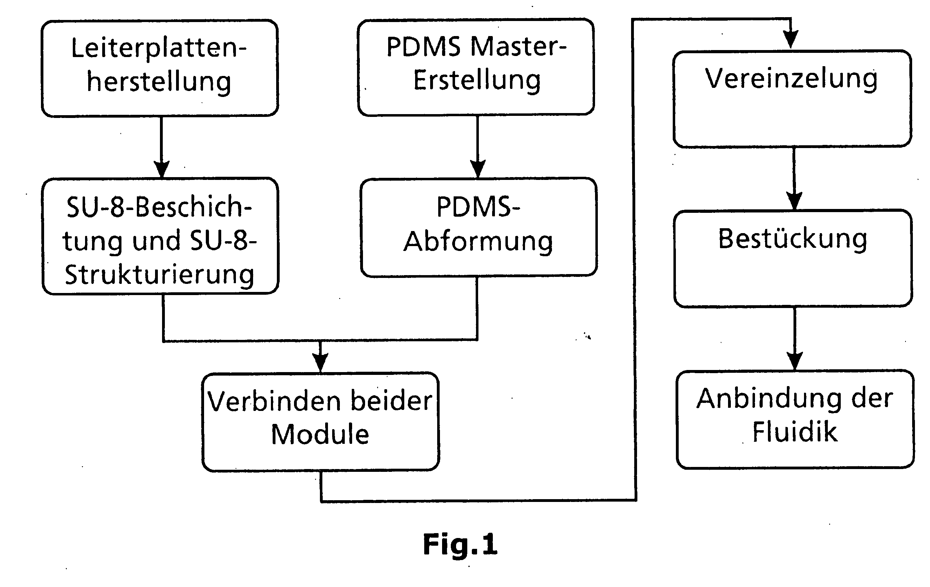

Die Herstellung des erfindungsgemäßen hybriden Biochips besteht z. B. aus einer Kombination von an sich bekannten Strukturierungs- und Abformverfahren der Mikrosystemtechnik, wie es beispielhaft in Fig. 1 angegeben ist.

Aus konventionellen Methoden wurden mit dem Substrat Polyimid als biokompatibles Leiterplatten-Basismaterial symmetrisch konzipierte, vierlagige Platinen gefertigt, die ein oder mehrere Chips mit Abmessungen von 2,8 cm x 3,2 cm enthalten. Dieses Format wurde gewählt, um etablierte Lithographieprozesse analog der etablierten 4"-Wafertechnologie zu nutzen. Die Durchkontaktierungen (Vias) zur Verbindung der einzelnen elektrischen Lagen wurden sowohl durch mechanische als auch Laserbohrungen realisiert. Die Kupfer-Leiterbahnen (Dimensionen: Höhe 17,5 µm, Breite 100 µm) und die Elektroden wurden mit einer chemisch inerten Goldschicht bedeckt, um eine gute Kompatibilität mit den biochemischen Lösungen zu gewährleisten. Daran schließt sich die Beschichtung und lithographische Strukturierung der Polymerschicht an, welche zum einen zur kompletten Planarisierung der PCB-Oberfläche dient, die Leiterbahnen von den Fluidikkanälen isoliert und zum anderen durch selektive Öffnung (Strukturdimension 60 µm x 60 µm) den Kontakt der Elektroden zu den mikrofluidischen Kanälen definiert. Als Polymer wurde SU-8 (microresist technologies, Berlin) verwendet, welches sich photolithografisch mit einem exzellenten Aspektverhältnis strukturieren lässt und sich nicht zuletzt durch seine biokompatiblen Eigenschaften für (Bio)MEMS-Anwendungen hervorragend eignet.

Die Fabrikation der mikrofluidischen Layer erfolgt mittels Mikroabformung von einem vorab erzeugten Master. Hierzu werden drei Strukturebenen in SU-8 auf einem Siliziumsubstrat erzeugt, aus der nach Abformung mit PDMS (Sylgard 184, Dow Corning) jeweils drei diskrete Kanaltiefen resultieren. Entsprechend Fig. 1 wird anschließend die in PDMS erzeugte Mikrofluidik durch ein plasmaunterstütztes Bondverfahren dauerhaft und irreversibel mit der auf dem Elektrodenlayer zuvor aufgebrachten Polymerschicht verbunden. Nach anschließender Vereinzelung der Chips wurden diese mittels Standard-Reflow-Technik mit einem programmierbaren Logikchip (z.B. FPGA, CPLD, µC) bestückt, der als Schnittstelle die Kommunikation zum externen Steuerrechner herstellt und die digitale elektrische Kontrolle der Aktorelektroden übernimmt.

Die wesentlichen neuen Aspekte der Erfindung lassen sich wie folgt stichpunktartig zusammenfassen:

### Konzept

- Ersetzung der Standard-Siliziumtechnologie durch Leiterplatinen als Basismaterial für mikrofluidische Anwendungen,
- dadurch:
   - kostengünstige Fertigung von elektrisch aktiven Biochips (siehe Fig. 1),
   - vereinfachtes Routing hochintegrierter Schaltungen durch mehrlagige PCBs,
   - zusätzliche Fluidikebenen durch eingebrachte, lithografisch strukturierbare Polymerschicht

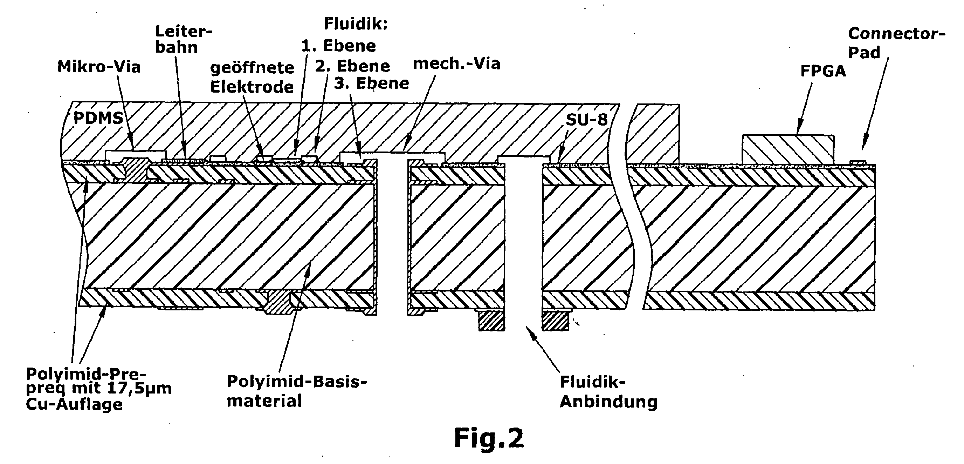

### Integrale Bestandteile (siehe Fig. 2)

- mehrlagige Leiterplatine als Basismaterial (hier im 100 µm-Design),
- lithografisch strukturierbare Polymerbeschichtung (hier SU-8),
- Fluid-Materiallage basierend auf Organosiloxane sowie deren Polymerisationsprodukte, Silikone, Polyacrylate (wie z.B. PMMA) und/oder Elastomere mit sauerstoff- und/oder stickstoffhaltigen funktionalen Gruppen (z.B. Polysulfon, -imid, -carbonat und/oder -acrylnitril (hier PDMS),
- programmierbarer Logikchip zur Steuerung der Elektroden auf dem Chip (z.B. FPGA, CPLD, µC),
- Connector-Pad (zur externen Spannungsversorgung)
- Fluidik-Steganbindung (zur Befüllung der Mikrokanäle)

### Aufgabe der Leiterplatine

- ist Basismaterial (hier gefertigt aus Polyimid-Verbundmaterial),
- kostengünstige Standardfertigung erlaubt mehrere elektrische Ebenen; individuelle Kontaktierung der Elektroden mit geringem Routingaufwand,
- oberster Layer (Elektroden) stellt Kontaktierung zur Fluidik dar,
- fungiert als fluidische Durchkontaktierung zur externen Fluidikanbindung

### Aufgaben Polymerschicht(-en)

- planarisiert die Oberfläche der Leiterplatine,
- ermöglicht eine vom Platinendesign unabhängige Strukturgröße der Elektroden,
- isoliert die Leiterbahnen gegenüber den Fluid-Kanälen,
- ermöglicht ein homogenes Bondverhalten vom PDMS gegenüber dem Platinenmaterial,
- dient als Lötstoppmaske bei der weiteren Verarbeitung
- dient als andersweitige physikalische Schutz- und/oder Trennschichten

### Aufgaben der Fluid-Materiallage (PDMS)

- Fertigung im Negativ-Abformverfahren (Softlithographie) mit Hilfe eines Masters,
- ist biokompatibel,
- kann selbst mehrere fluidische Ebenen enthalten,
- besitzt sehr gute optische Eigenschaften zur Online-Überwachung

### Aufgaben programmierbarer Logikchips (z.B. FPGA, CPLD, µC)

- übernimmt die Ansteuerung der Elektroden (beispielsweise für den elektrokinetischen Transport von Biomolekülen in den mikrofluidischen Kanälen),
- stellt die Schnittstelle zum über die elektrische Steckverbindung angeschlossenen, externen Rechner dar

### Zusammenfassung der wesentlichen Aspekte der Erfindung

- Leiterplatine als Basismaterial ermöglicht es erstmalig, mehrere elektrische Layer auf hybriden Biochips zu integrieren,
- einfaches Routing komplexer Schaltungen bei nahezu beliebiger Skalierbarkeit,
- über die für die Anwendung angepasste Polymerschicht ist die vertikale Integration von mikrofluidischen Komponenten und elektrischen Layern auf Platinenbasis möglich.

## Patentansprüche

1. Mikrofluidik-System mit
- einer Leiterplatine, die eine Polymer-Trägerschicht aufweist, wobei mindestens eine Seite der Trägerschicht mit einer elektrisch leitenden Schicht versehen ist, die mehrere Elektroden aufweist, und auf die elektrisch leitende Schicht unter Freilassung zumindest einer der Elektroden eine oder mehrere photolithographisch bzw. mittels Elektronenstrahl strukturierbare Lack- bzw. Polymerschicht auf Acryl-, Epoxidharz, Phenolharz-, Siliconharz- Fluorpolymerbasis aufgebracht ist, und
- einer oder mehrerer Mikrokanal-Materiallage mit einer Außenseite, in die Mikrokanäle bildende Vertiefungen eingebracht sind,
- wobei die Materiallage PDMS, andere Organosiloxane sowie deren Polymerisationsprodukte, Silikone, Polyacrylate, und/oder Elastomere mit sauerstoff- und/oder stickstoffhaltigen funktionalen Gruppen aufweist,
- wobei die Vertiefungen aufweisende Außenseite der Mikrokanal-Materiallage die Photolackschicht der Leiterplatine derart kontaktiert, dass die Elektroden mit jeweils einer der Vertiefungen fluchtet und
- wobei die Außenseite der Materiallage fluiddicht mit der Lack- bzw. Polymerschicht der Leiterplatine verbunden ist.

2. Mikrofluidik-System nach Anspruch 1, **dadurch gekennzeichnet, dass** die Photolackschicht das Epoxidharz SU-8^{®} (MicroChem Corp.), Bisbenzocyclobuten oder CY-TOP^{®} (Asahi Glass Company) aufweist.

3. Mikrofluidik-System nach einem der Ansprüche 1 oder 2, **dadurch gekennzeichnet, dass** die Herstellung einer fluiddichten Verbindung zwischen der Außenseite der Mikrokanal-Materiallage und der Lack- bzw. Polymerschicht der Leiterplatine Plasma unterstützt ist.

4. Mikrofluidik-System nach einem der Ansprüche 1 bis 3, **dadurch gekennzeichnet, dass** die Leiterplatine auf der mindestens eine ihrer beiden Seiten eine mehrlagige elektrisch leitende Schicht mit mehreren gegeneinander elektrisch isolierten elektrisch leitenden Schichten aufweist, von denen die oberste die Elektroden aufweist.

5. Mikrofluidik-System nach einem der Ansprüche 1 bis 4, **dadurch gekennzeichnet, dass** die Leiterplatine beidseitig mit jeweils einer ein- oder mehrlagigen elektrisch leitenden Schicht versehen ist und Durchkontaktierungsöffnungen zur elektrischen Verbindung der elektrisch leitenden Schichten aufweist.

6. Mikrofluidik-System nach einem der Ansprüche 1 bis 5, **dadurch gekennzeichnet, dass** die Leiterplatine zur Fluidanbindung der Mikrokanäle mindestens einen Fluidkanal aufweist, der sich von der mit der Mikrokanal-Materiallage verbundenen einen Seite der Leiterplatine zu deren gegenüberliegenden anderen Seite erstreckt.

7. Mikrofluidik-System nach einem der Ansprüche 1 bis 6, **dadurch gekennzeichnet, dass** in die Polymer-Trägerschicht bzw. in mindestens eine der Polymer-Trägerschichten Mikrokanäle bildende Vertiefungen ausgebildet sind, und zwar vorzugsweise durch lithographische Strukturierung.

8. Verfahren zum Herstellen eines Mikrofluidik-Systems, insbesondere nach einem der vorhergehenden Ansprüche, mit den folgenden Schritten:
- Bereitstellen einer Leiterplatine, die eine Polymer-Trägerschicht (Platinenmaterial) aufweist, wobei mindestens eine Seite der Trägerschicht mit einer elektrisch leitenden Schicht versehen ist, die mehrere Elektroden aufweist,
- Aufbringen einer oder mehrerer Lack- bzw. Polymerschicht(en) auf Acryl-, Epoxidharz-, Phenolharz-, Silikonharz- bzw. Fluorpolymerbasis,
- Strukturieren der Lack- bzw. Polymerschicht(en), und zwar fotolithographisch bzw. mittels Elektronenstrahl, zur Erzeugung von in der Lack- bzw. Polymerschicht(en) freigelegten Elektroden,
- Bereitstellen einer oder mehrerer Mikrokanal-Materiallage(n) mit jeweils einer Außenseite, in die Mikrokanäle bildende Vertiefungen eingebracht sind, und
- Verbinden der Außenseite jeder Mikrokanal-Materiallage mit einer der Lack- bzw. Polymerschicht(en) auf der Leiterplatine zum fluiddichten Verbinden beider, wobei mindestens zwei der Elektroden mit jeweils einer der Vertiefungen der Mikrokanal-Materiallage(n) fluchtet.

## Claims

1. A microfluidic system comprising:
- a printed circuit board comprising a polymer support layer, at least one surface of the support layer being provided with an electrically conductive layer including a plurality of electrodes, and said electrically conductive layer is provided with one or more varnish or polymer layer(s) based on acryl, epoxy resin, phenolic resin, silicon resin or fluorinated polymer, said layer(s) being adapted to be patterned by photolithography or electron beam while leaving at least one of said electrodes exposed, and
- one or more microchannel material layer(s) with an outer surface provided with recesses forming said microchannels,
- the material layer comprising PDMS, other organic siloxanes, as well as their polymerization products, silicones, polyacrylates and/or elastomeres with functional groups containing oxygen and/or nitrogen (e.g. polysulphone, polycarbonate and/or polyacrylonitrile),
- the recessed outer surface of the microchannel material layer contacting the photoresist layer of the printed circuit board such that said at least one electrode is aligned with one of said recesses, and
- the outer surface of the material layer being fluid-tightly connected with the varnish or polymer layer of the printed circuit board.

2. The microfluidic system of claim 1, wherein the photoresist layer comprises the epoxy resin SU-8^{®} (MicroChem Corp.), bisbenzocyclobutene or CYTOP^{®} (Asahi Glass Company).

3. The microfluidic system of claim 1 or 2, wherein the forming of a fluid-tight connection between the outer side of the microchannel material layer and the varnish or polymer layer may advantageously be assisted by a plasma.

4. The microfluidic system of one of claims 1 to 3, wherein the printed circuit board has at least one of its two sides provided with an electrically conductive multilayer layer structure comprising a plurality of electrically conductive layers electrically insulated from each other, the topmost of these layers comprising the electrode.

5. The microfluidic system of one of claims 1 to 4, wherein the printed circuit board is advantageously provided with a single or multilayer electrically conductive layer on each of its two sides and has via openings for the electrical connection of the electrically conductive layers.

6. The microfluidic system of one of claims 1 to 5, wherein the printed circuit board comprises at least one fluid channel for establishing the fluid communication of the microchannels, which fluid channel extends from the circuit board side connected with the microchannel material layer to the other, opposite side thereof.

7. The microfluidic system of one of claims 1 to 6, wherein recesses forming microchannels are formed in the polymeric support layer or in at least one of the polymeric support layers, the recesses preferably being formed by lithographic structuring.

8. A method for manufacturing a microfluidic system, in particular of one of the preceding claims, comprising the following steps:
- providing a printed circuit board comprising a polymeric support layer (circuit board material), at least one surface of the support layer being provided with an electrically conductive layer including a plurality of electrodes,
- depositing one or more varnish or polymer layer(s) based on acryl, epoxy resin, phenolic resin, silicon resin or fluorinated polymer,
- structuring said varnish or polymer layer(s) by photolithography or electron beam to produce electrodes exposed in said varnish or polymer layer(s),
- providing one or more microchannel material layer(s) with a respective outer surface provided with recesses forming microchannels, and
- bonding the outer surface of each microchannel material layer with one of the varnish or polymer layers on the printed circuit board for the fluid-tight connection of both, at least two electrodes being aligned with a respective one of said recesses in the microchannel material layer(s).

## Revendications

1. Système de microfluidique comportant :
- une platine de conduction, qui comprend une couche-substrat en polymère, étant précisé qu'une face, au moins, de la couche-substrat est pourvue d'une couche électriquement conductrice, qui présente plusieurs électrodes, et que, sur la couche électriquement conductrice, est appliquée, en laissant libre au moins l'une des électrodes, une ou plusieurs couches de vernis ou de polymère à base de résine acrylique, de résine époxy, de résine phénolique, de résine aux silicones, de polymère fluoré, structurables par photolithographie ou au moyen d'un faisceau électronique, et
- une ou plusieurs épaisseurs de matériau à microcanaux, présentant une face extérieure dans laquelle des renfoncements formant des microcanaux sont pratiqués,
- l'épaisseur de matériau comprenant du PDMS, d'autres organosiloxanes ainsi que leurs produits de polymérisation, des silicones, des polyacrylates et/ou des élastomères comportant des groupes fonctionnels oxygénés et/ou azotés,
- la face extérieure, comprenant des renfoncements, de l'épaisseur de matériau à microcanaux étant en contact avec la couche de vernis photosensible de la platine de conduction d'une manière telle, que les électrodes soient alignées chacune avec l'un des renfoncements, et
- la face extérieure de l'épaisseur de matériau est reliée, d'une façon étanche aux fluides, à la couche de vernis ou de polymère de la platine de conduction.

2. Système de microfluidique selon la revendication 1, **caractérisé en ce que** la couche de vernis photosensible comprend la résine époxy SU-8^{®} (MicroChem Corp.), le bisbenzocyclobutène ou le CY-TOP^{®} (Asahi Glass Company).

3. Système de microfluidique selon l'une des revendications 1 ou 2, **caractérisé en ce que** l'établissement d'une liaison étanche aux fluides entre la face extérieure de l'épaisseur de matériau à microcanaux et la couche de vernis ou de polymère de la platine de conduction est assisté par plasma.

4. Système de microfluidique selon l'une des revendications 1 à 3, **caractérisé en ce que** la platine de conduction présente, sur la au moins une de ses deux faces, une couche électriquement conductrice en plusieurs épaisseurs comportant plusieurs couches électriquement conductrices, isolées électriquement l'une par rapport à l'autre, dont la plus haute comprend les électrodes.

5. Système de microfluidique selon l'une des revendications 1 à 4, **caractérisé en ce que** la platine de conduction est pourvue, sur chacune des deux faces, d'une couche électriquement conductrice en une ou plusieurs épaisseurs, et présente des ouvertures de contact traversantes en vue du raccordement électrique des couches électriquement conductrices.

6. Système de microfluidique selon l'une des revendications 1 à 5, **caractérisé en ce que** la platine de conduction, en vue de la liaison de passage de fluide des microcanaux présente au moins un canal à fluide, qui s'étend de l'une des faces de la platine de conduction, reliée à l'épaisseur de matériau à microcanaux, à son autre face opposée.

7. Système de microfluidique selon l'une des revendications 1 à 6, **caractérisé en ce que** des renfoncements formant des microcanaux sont ménagés, de préférence par structuration lithographique, dans la couche-substrat en polymère ou dans l'une au moins des couches-substrats en polymère.

8. Procédé pour produire un système de microfluidique, en particulier selon l'une des revendications précédentes, présentant les étapes suivantes :
- mise à disposition d'une platine de conduction, qui comprend une couche-substrat en polymère (matériau de la platine), une face au moins de la couche-substrat étant pourvue d'une couche électriquement conductrice qui présente plusieurs électrodes,
- application d'une ou de plusieurs couche(s) de vernis ou de polymère, à base de résine acrylique, de résine époxy, de résine phénolique, de résine aux silicones ou de polymère fluoré,
- structuration de la ou des couche(s) de vernis ou de polymère, plus précisément par photolithographie ou au moyen d'un faisceau électronique, pour la réalisation d'électrodes dégagées dans la ou les couche(s) de vernis ou de polymère,
- mise à disposition d'une ou de plusieurs épaisseur(s) de matériau à microcanaux, présentant chacune une face extérieure dans laquelle des renfoncements formant des microcanaux sont pratiqués, et
- liaison de la face extérieure de chaque épaisseur de matériau à microcanaux à l'une des couches de vernis ou de polymère sur la platine de conduction, en vue du raccordement, étanche aux fluides, des deux, au moins deux des électrodes étant alignées chacune avec l'un des renfoncements de la ou des épaisseur(s) de matériau à microcanaux.
